Europäisches Patentamt

European Patent Office

Office européen des brevets

(19)

(11) **EP 1 227 593 A1**

(12) **EUROPÄISCHE PATENTANMELDUNG**

(43) Veröffentlichungstag:
**31.07.2002 Patentblatt 2002/31**

(51) Int Cl.[7]: **H03M 3/02**

(21) Anmeldenummer: **01101968.4**

(22) Anmeldetag: **29.01.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **SIEMENS AKTIENGESELLSCHAFT 80333 München (DE)**

(72) Erfinder:
• **Jelonnek, Bjoern, Dr. 89079 Ulm (DE)**
• **Splett, Armin, Dr. 89081 Ulm (DE)**

(54) **Anordnung zum Laufzeitausgleich einer durch eine Nachbildung eines Hochfrequenzsignals auftretenden Laufzeitdifferenz**

(57) Es wird eine Anordnung zum Laufzeitausgleich einer durch eine Nachbildung eines Hochfrequenzsignals auftretenden Laufzeitdifferenz mit einem nachzubildenden Signal x(t), mit einer Signalverarbeitungseinrichtung, welche das Signal x(t) durch ein Signal $\hat{x}(t)$ nachbildet, und mit einer Einrichtung zur Ermittlung eines Differenzsignals der Signale x(t) und $\hat{x}(t)$ beschrieben, welche dadurch gekennzeichnet ist, dass das nachgebildete Signal $\hat{x}(t)$ über ein Filter mit für bestimmte Frequenzbereiche negativer Gruppenlaufzeit geführt wird.

– Figur 2 –

**Beschreibung**

Die vorliegende Erfindung betrifft eine Anordnung zum Laufzeitausgleich einer durch eine Nachbildung eines Hochfrequenzsignals auftretenden Laufzeitdifferenz nach dem Oberbegriff des Anspruchs 1.

Hochfrequente Signale, welche mittels beliebiger Übertragungssysteme linearer oder nichtlinearer Art, wie beispielsweise Verstärkerketten übertragen werden, können durch Signalverarbeitungseinrichtungen nachgebildet werden. Ein Beispiel eines Übertragungssystems zeigt die von der Anmelderin mit gleichem Anmeldetag eingereichte Patentanmeldung, betreffend einen Sigma-Delta-Modulator zur Digitalisierung von analogen Hochfrequenzsignalen. Im Idealfall erfolgt die Signalnachbildung des Ausgangssignals des Übertragungssystems dabei ohne Zeitverzögerung gegenüber dem ursprünglichen Signal, so dass die exakt nachgebildeten Signalanteile des nachgebildeten Signals das ursprüngliche Signal in einem Differenzsignal vollständig auslöschen.

Praktische Realisierungen der Signalnachbildung verursachen jedoch in der Regel eine Laufzeitdifferenz des nachgebildeten gegenüber dem ursprünglichen Signal. Wie nachstehend verdeutlicht werden kann, führt die Zeitverzögerung des nachgebildeten Signals zu einer Auslöschung der Signalanteile nur in einem gewissen Frequenzbereich. Hierbei bezeichnet $x(t)$ das ursprüngliche Ausgangssignal des Übertragungssystems und $\hat{x}(t)$ das nachgebildete Signal; $\tau$ steht fór die Laufzeitdifferenz des nachgebildeten Signals.

Es gilt die Beziehung

$$x(t)-\overset{\wedge}{x}(t) \approx x(t)- x(t\text{-}\tau) \Leftrightarrow X(j\omega)-e^{-j\omega\tau}X(j\omega)=X(j\omega)\cdot(1-e^{-j\omega\tau})$$

Um eine breitbandige Signalauslöschung zu erzielen, ist der Einsatz von Laufzeitgliedern üblich, die das Signal $x(t)$ um die Zeitdauer der Laufzeitdifferenz $\tau$ der Signalnachbildung $\hat{x}(t)$ verzögern.

$$x(t\text{-}\tau)-\overset{\wedge}{x}(t) \approx x(t\text{-}\tau)\text{-}x(t\text{-}\tau)=0$$

Die hierzu eingesetzten hochlinearen Laufzeitglieder sind aufgrund der hohen spektralen Reinheit des Signals $x(t)$ technisch aufwendig und verursachen hohe Herstellungskosten.

Aufgabe der Erfindung ist es daher, eine Anordnung zum Laufzeitausgleich einer durch eine Nachbildung eines Hochfrequenzsignals auftretenden Laufzeitdifferenz zu schaffen, die eine breitbandige Signalnachbildung ermöglicht und dabei technisch einfach realisierbar ist.

Die Aufgabe wird gelöst durch eine Anordnung zum Laufzeitausgleich einer durch eine Nachbildung eines Hochfrequenzsignals auftretenden Laufzeitdifferenz mit einem nachzubildenden Signal $x(t)$, mit einer Signalverarbeitungseinrichtung, welche das Signal $x(t)$ durch ein Signal $\hat{x}(t)$ nachbildet, und mit einer Einrichtung zur Ermittlung eines Differenzsignals der Signale $x(t)$ und $\hat{x}(t)$ , welche dadurch gekennzeichnet ist, dass das nachgebildete Signal $\hat{x}(t)$ über ein Filter mit für bestimmte Frequenzbereiche negativer Gruppenlaufzeit geführt wird. Dabei werden die Parameter des Filters derart gewählt, dass die Gesamtübertragungsfunktion des Differenzsignals in dem gewünschten Frequenzbereich Nullstellen aufweist bzw. stark gedämpft wird. In diesem Frequenzbereich wird somit die aus der Signalnachbildung resultierende Laufzeitdifferenz weitestgehend kompensiert.

Nach einer Ausführungsform der Erfindung bildet das Signal x(t) das Ausgangssignal eines Übertragungssystems und ein Signal u(t) bildet das Eingangssignal des Übertragungssystems. Das Übertragungssystem kann hierbei z.B. aus einem Verstärker oder auch einer Verstärkerkette bestehen. Es kann aber ein beliebiges lineares oder nichtlineares Übertragungssystem eingesetzt werden.

Gemäß einer weiteren Ausführungsform der Erfindung weist die Anordnung eine Regelungseinrichtung auf, durch die das nachgebildete Signal $\hat{x}(t)$ veränderbar ist, derart, dass das Differenzsignal minimal wird.

Bevorzugt wird das Differenzsignal zur Regelung der Signalnachbildung zu der Signalverarbeitungseinrichtung geführt.

Nach einer Ausführungsform der Erfindung ist eine Signalauswertungseinheit vorgesehen, welche das Differenzsignal auswertet und das ausgewertete Signal zu der Signalverarbeitungseinrichtung führt.

Nach einer bevorzugten Ausführungsform der Erfindung wird das analoge Eingangssignal zur Steuerung der Signalnachbildung zu der Signalverarbeitungseinrichtung geführt.

Bevorzugt weist das Filter Laufzeitglieder auf, welche das digitale Signal verzögern.

Vorzugsweise wird zur Lösung der Aufgabe ein lineares Filter eingesetzt. Es kann beispielsweise ein FIR-, ein IIR oder auch jedes andere lineare Filter verwendet werden.

Ausführungsbeispiele der Erfindung werden nachstehend anhand der beiliegenden Zeichnungen erläutert.

Dabei zeigen:

Fig. 1    eine Darstellung einer Anordnung zur Signalnachbildung gemäß dem Stand der Technik,

Fig. 2    eine Darstellung einer erfindungsgemäßen Anordnung zur Signalnachbildung,

Fig. 3    eine Darstellung einer weiteren Ausführungsform einer erfindungsgemäßen Anordnung zur Signalnachbildung,

Fig. 4    eine Darstellung eines Anwendungsbeispiels der erfindungsgemäßen Anordnung zur Signalnachbildung, und

Fig. 5    eine Darstellung einer zweiten Ausführungsform einer erfindungsgemäßen Anordnung zur Signalnachbildung.

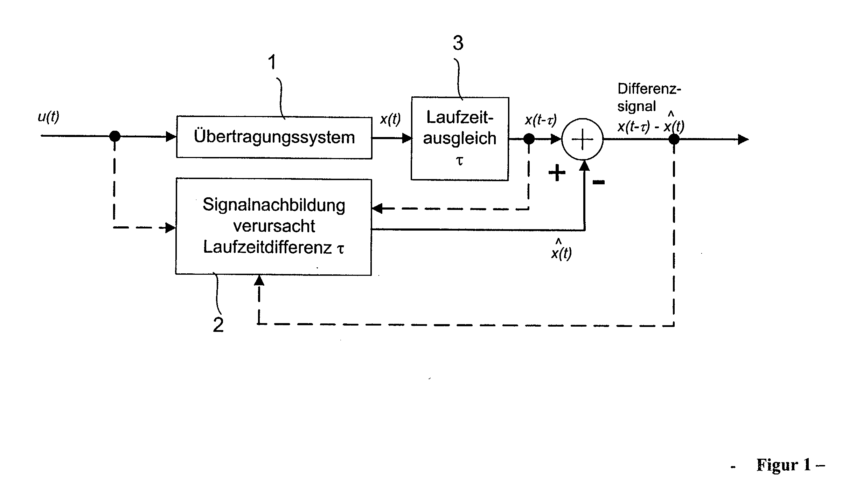

Die in Fig. 1 gezeigte Anordnung zur Signalnachbildung, wie sie aus dem Stand bekannt ist, weist ein Eingangssignal u(t) auf, welches durch ein beliebiges lineares oder nichtlineares Übertragungssystem 1 übertragen wird. Am Ausgang des Übertragungssystems 1 liegt das Signal x(t) an. Das Signal x(t) wird in der Signalverarbeitungseinrichtung 2 nachgebildet, wobei Laufzeitdifferenzen, d.h. Verzögerungen gegenüber dem Signal x(t) auftreten. Am Ausgang der Signalverarbeitungseinrichtung 2 liegt das Signal $\hat{x}(t)$ an. Zum Ausgleich der Laufzeitdifferenzen ist für das Signal x(t) ein Laufzeitglied 3 vorgesehen, welches das Signal x(t) um eine Zeit τ verzögert. Dabei wird τ vorzugsweise derart gewählt, dass es der durch die Signalverarbeitungseinrichtung 2 verursachten Laufzeitdifferenz entspricht. Eine ideale Signalnachbildung sowie eine Verzögerung τ vorausgesetzt, welche exakt der durch die Signalnachbildung hervorgerufenen Signalverzögerung entspricht, gilt für das aus $\hat{x}(t)$ und dem verzögerten Signal x(t-τ) gebildete Differenzsignal x(t-τ) -$\hat{x}(t)$ für alle Frequenzen

$$x(t\text{-}\tau)\text{-}\overset{\wedge}{x}(t) = 0$$

Zur Verbesserung der Signalnachbildung kann ein Regelkreis gebildet werden, der das Differenzsignal, welches im Normalfall ungleich 0 ist, an die Signalverarbeitungseinrichtung 2 sendet. Es kann auch das verzögerte Signal x(t-τ) als Regelgröße verwendet werden.

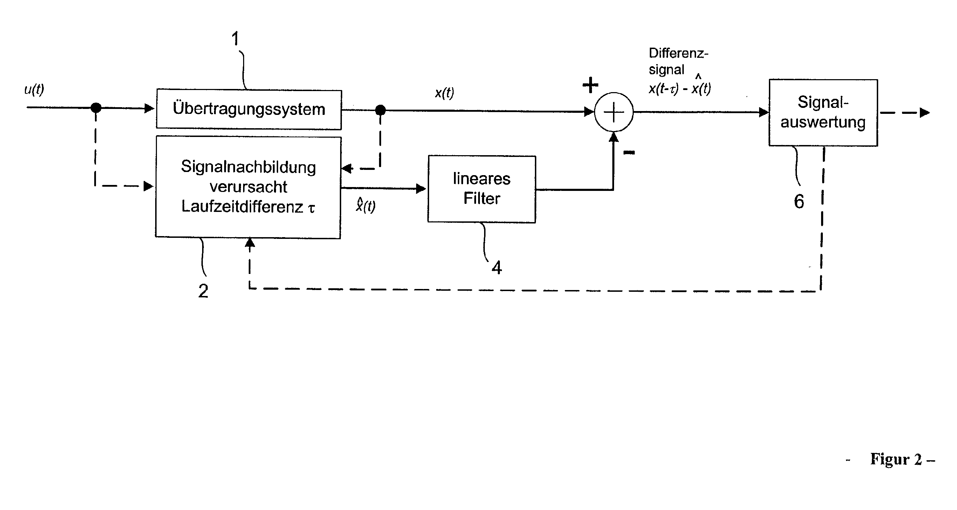

Gemäß der vorliegenden Erfindung wird auf den Einsatz eines Laufzeitglieds zur Kompensation der Laufzeitdifferenz verzichtet. Eine Darstellung der Erfindung zeigt Fig. 2.

Das nachgebildete Signal $\hat{x}(t)$ wird als Eingangssignal auf ein lineares Filter 4 gegeben. Es kann dabei ein FIR-, IIR- oder ein beliebiges anderes lineares Filter eingesetzt werden. Die Koeffizienten des linearen Filters werden derart gewählt, dass für bestimmte Frequenzbereiche die durch die Signalverarbeitungseinrichtung 2 verursachte Laufzeitdifferenz durch das lineare Filter kompensiert wird. Das eingesetzte Filter weist in den bestimmten Frequenzbereichen eine negative Gruppenlaufzeit auf, ist aber wegen positiver Gruppenlaufzeiten in anderen Frequenzbereichen, d.h. Verzögerungen des Signals, dennoch kausal und daher realisierbar. Auf diese Weise wird im gewünschten Frequenzbereich eine Signalnachbildung erreicht, welche im Vergleich zu bisherigen Lösungen breitbandiger und aufgrund der eingesetzten digitalen Filter einfach zu realisieren ist. Das an dem Summierer 5 gebildete Differenzsignal kann als Regelgröße für die Signalverarbeitungseinrichtung 2 eingesetzt werden. Es ist jedoch auch denkbar, eine Auswertung des Differenzsignals als Regelgröße heranzuziehen. Hierzu wird eine Signalauswertungseinheit 6 eingesetzt, welche beispielsweise das Differenzsignal in eine Taylorreihe umwandelt. Es können erfindungsgemäß auch andere Arten der Signalzerlegung eingesetzt werden.

Ein weiteres Beispiel für eine Signalzerlegung ist die Spektralanalyse (Fourieranalyse) des Differenzsignals. Ziel ist es, die Leistung des Differenzsignals innerhalb eines Teilbandes zu minimieren. Hierfür ist es ausreichend, diejenigen Ergebnisse der Spektralanalyse des Differenzsignals an die Signalverarbeitungseinrichtung 2 zu senden, die den Frequenzgang innerhalb des betrachteten Teilbandes beschreiben.

Als weitere alternative parametrische Regelgröße kann die Leistung des Fehlersignals innerhalb des betrachteten Frequenzbandes verwendet werden.

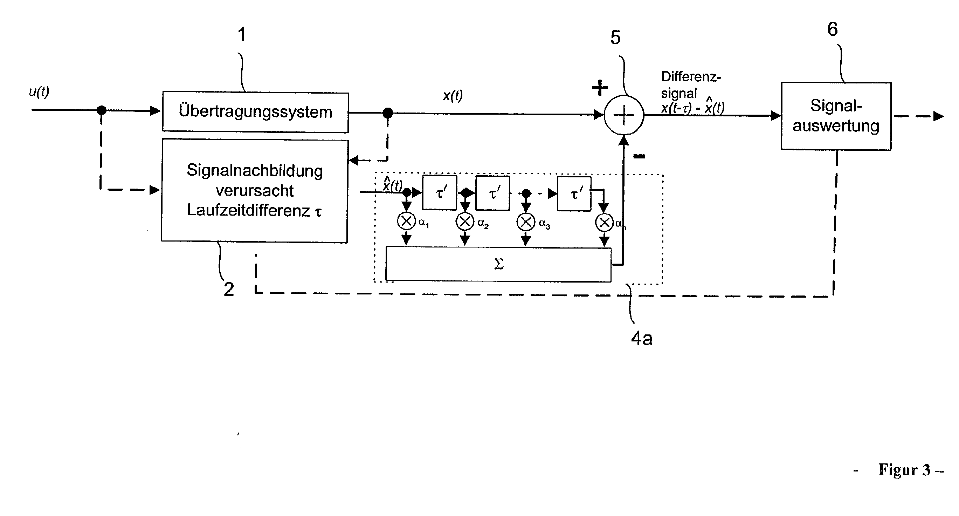

Im folgenden wird eine Ausführungsform der Erfindung an einem Beispiel nach Fig. 3 beschrieben. In diesem Beispiel wird ein FIR-Filter 4a zur Erzielung der negativen Gruppenlaufzeit für bestimmte Frequenzbereiche verwendet. Es soll ein Laufzeitausgleich im Tiefpaßbereich vorgenommen werden. Für die Verzögerungsglieder τ' des Filters soll gelten

$$\tau' = \tau,$$

d.h. die Verzögerungsglieder t' des Filters entsprechen jeweils der Laufzeitdifferenz t der Signalverarbeitungseinrichtung. Den Ausgangspunkt bildet ein linearer Filterentwurf mit guter Sperrdämpfung bei der Frequenz $\underline{\omega}$ = 0:

$$H_{Entwurf} = 1 - \sum_{l=1}^{q-1} \alpha_l z^{-l}$$

mit q = 1, 2, 3, ... und 1 = 1, 2, 3, ....

In diesem Beispiel wird

$$H_{Entwurf} = (1 - z^{-1})^v \text{ mit } v=2 \text{ und } z=e^{j\omega\tau}$$

gewählt. Es ergibt sich somit für das Differenzsignal $y(t)$ am Ausgang des Summierers 5

$$y(t) = x(t) + \sum_{l=1}^{q-1} \alpha_l \hat{x}(t-(l-1)\tau) = x(t) - 2\hat{x}(t) + \hat{x}(t-\tau) \approx x(t) - 2x(t-\tau) + x(t-2\tau)$$

Aus der Linearität der Fouriertransformation folgt

$$Y(e^{j\omega}) = (1-e^{-j\omega\tau})^2 X(e^{j\omega}) = (1- 2e^{-j\omega\tau} + e^{-j\omega2\tau}) X(e^{j\omega})$$

$$= X(e^{j\omega}) - 2e^{-j\omega\tau} X(e^{j\omega}) + e^{-j\omega2\tau} x(e^{j\omega})$$

korrespondiert mit

$$y(t) = x(t) - 2x(t-\tau) + x(t+2\tau)$$

Die Definition der Gruppenlaufzeit nach K. D. Kammeyer, Nachrichtenübertragung, Teubner Stuttgart 1996, lautet wie folgt

$$\tau_g(\omega) = -\frac{d\phi(\omega)}{d\omega}$$

Frequenzgang des betrachteten Teilsystems

$$H_{teil} = 2 - e^{-j\omega\tau}$$

Bei Frequenzen $\omega\tau \approx 2\pi$ ist $e^{-j\omega2\pi} \approx 1-j(\omega\tau-2\pi)$ (Taylorreihenentwicklung). Damit gilt annähernd

$$H_{teil} = 2-(1-j(\omega\tau-2\pi)) = 1+ j(\omega\tau-2\pi))$$

Die Phase beträgt approximativ $\omega\tau-2\pi$, die Ableitung nach $\omega$ ergibt negative Werte: $-\tau$ ist diejenige Gruppenlaufzeit, die kompensiert werden soll.

Für das dargestellte Filter werden daher die Koeffizienten $\alpha_1 ... \alpha_n$ wie folgt gewählt : $\alpha_1 = 2$, $\alpha_2 = -1$ und $\alpha_3... \alpha_n = 0$

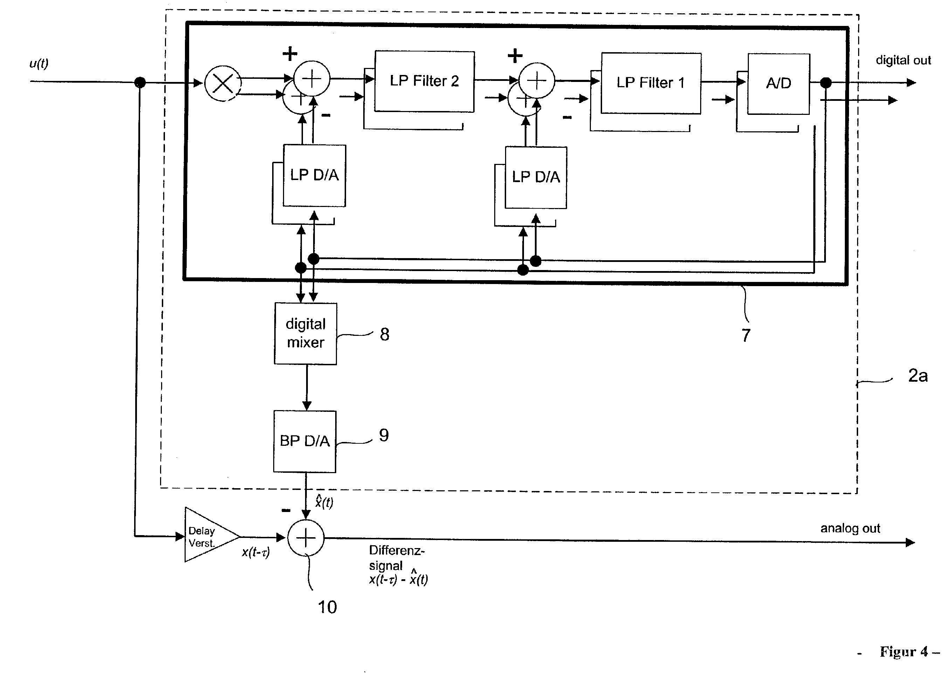

Ein konkretes Anwendungsbeispiel der Erfindung zeigt Fig. 4. Es ist eine Kaskadenstufe eines Analog-Digital-Wandlersystems mit einem Tiefpaß-Sigma-Delta-Modulator 7 dargestellt, welches Gegenstand einer weiteren Patentanmeldung der Anmelderin ist. Die digitale Signalnachbildung des analogen Eingangssignals u(t) wird hier durch den Tiefpaß-Sigma-Delta-Modulator 7 erzielt. Die beiden Ausgangssignale einer Signalverarbeitungseinrichtung 2a, welche durch die Multiplikation des Eingangssignals u(t) mit ein sin- bzw. einem cos-Signal entstehen und als Inphase- bzw. Quadraturkomponente bezeichnet werden, werden in dem digitalen Mischer 8 wieder zu einem Signal zusammengesetzt und anschließend in einem Bandpaß-Digital-Analog-Wandler 9 analogisiert. Das Ausgangssignal des Bandpaß-Digital-Analog-Wandlers 9 wird mit negativem Vorzeichen auf einen Summierer 10 geführt. Das Eingangssignal u(t) wird zur Amplitudenanpassung in einem Verstärker 11 verstärkt und gelangt zu dem Summierer 10. Gemäß dem Stand der Technik wird das Signal u(t) zusätzlich verzögert, um die durch die Signalverarbeitungseinrichtung 2a eingebrachte Verzögerung des Eingangssignals auszugleichen.

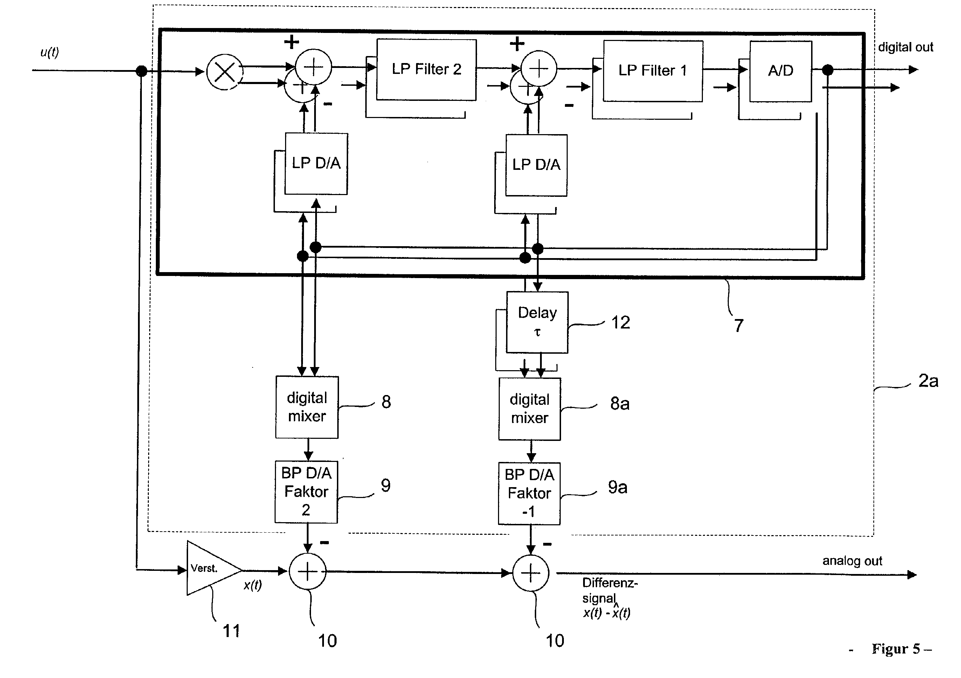

Eine erfindungsgemäße Realisierung eines Laufzeitausgleichs ausgehend von dem in Fig. 4 dargestellten Anwendungsbeispiel zeigt Fig. 5. Es wird hier ein digitales Filter mit den Koeffizienten $\alpha_1 = 2$ und $\alpha_2 = -1$ eingesetzt. Wie obenstehend beschrieben, weist dieses Filter eine hohe Sperrdämpfung bei $\omega = 0$ auf. Die Inphase- und die Quadraturkomponente des Tiefpaß-Sigma-Delta-Modulators 7 werden zum einen über einen digitalen Mischer 8 geführt, mit dem Koeffizienten $\alpha_1 = 2$ multipliziert und in einem Bandpaß-Digital-Analog-Wandler 9 in ein analoges Signal umgewandelt.

Anschließend wird das Signal mit negativem Vorzeichen einem Summierer 10 zugeführt. Ferner werden die Inphase- und die Quadraturkomponente des Tiefpaß-Sigma-Delta-Modulators 7 in einem Verzögerungsglied 12 um $\tau$ verzögert, in einem Mischer 8a zusammengeführt und mit dem Koeffizienten $\alpha_2 = -1$ multipliziert. Nach einer Umwandlung in ein analoges Signal in einem Bandpaß-Digital-Analog-Wandler 9a wird dieses dem Summierer 10 mit negativem Vorzeichen zugeführt. Das Eingangssignal u(t) erfährt eine Amplitudenanpassung mittels eines Verstärkers 11, wird jedoch nicht wie in Fig. 4 verzögert. Durch das den digitalen Mischern nachgeschaltete Filter weisen Frequenzen im Bereich $\omega = 2\pi$ eine negative Gruppenlaufzeit <u>auf</u>, so dass die durch die Signalverarbeitungseinrichtung 2a verursachte Verzögerung für diesen Frequenzbereich kompensiert wird. In anderen Frequenzbereichen ist die Gruppenlaufzeit zwar positiv, jedoch ist das Ausgangssignal ohnehin bandbegrenzt, so dass keine zusätzliche Einschränkung durch das digitale Filter entsteht.

**Patentansprüche**

1. Anordnung zum Laufzeitausgleich einer durch eine Nachbildung eines Hochfrequenzsignals auftretenden Laufzeitdifferenz mit einem nachzubildenden Signal x(t), mit einer Signalverarbeitungseinrichtung, welche das Signal x(t) durch ein Signal $\hat{x}(t)$ nachbildet, und mit einer Einrichtung zur Ermittlung eines Differenzsignals der Signale x(t) und $\hat{x}(t)$ , **dadurch gekennzeichnet, dass** das nachgebildete Signal $\hat{x}(t)$ über ein Filter mit für bestimmte Frequenzbereiche negativer Gruppenlaufzeit geführt wird.

2. Anordnung nach Anspruch 1, **dadurch gekennzeichnet, dass** das Signal x(t) das Ausgangssignal eines Übertragungssystems bildet und ein Signal u(t) das Eingangssignal des Übertragungssystems bildet.

3. Anordnung nach Anspruch 1 oder 2, **dadurch gekennzeichnet, dass** sie eine Regelungseinrichtung aufweist, durch die das nachgebildete Signal $\hat{x}(t)$ veränderbar ist, derart, dass das Differenzsignal minimal wird.

4. Anordnung nach Anspruch 3, **dadurch gekennzeichnet, dass** das Differenzsignal zur Regelung der Signalnachbildung zu der Signalverarbeitungseinrichtung geführt wird.

5. Anordnung nach einem der vorhergehenden Ansprüche, **dadurch gekennzeichnet, dass** eine Signalauswertungseinheit vorgesehen ist, welche das Differenzsignal auswertet und das ausgewertete Signal zu der Signalverarbeitungseinrichtung führt.

6. Anordnung nach einem der vorhergehenden Ansprüche, **dadurch gekennzeichnet, dass** das analoge Eingangssignal zur Steuerung der Signalnachbildung zu der Signalverarbeitungseinrichtung geführt wird.

7. Anordnung nach einem der vorhergehenden Ansprüche, **dadurch gekennzeichnet, dass** das Filter Laufzeitglieder aufweist.

8. Anordnung nach einem der vorhergehenden Ansprüche, **dadurch gekennzeichnet, dass** das Filter linear ist.

9. Anordnung nach einem der Ansprüche 1 bis 8, **dadurch gekennzeichnet, dass** das Filter ein FIR-Filter ist.

10. Anordnung nach einem der Ansprüche 1 bis 8, **dadurch gekennzeichnet, dass** das Filter ein IIR-Filter ist.

— Figur 1 —

Übertragungssystem

Signalnachbildung
verursacht
Laufzeitdifferenz τ

lineares
Filter

Signalauswertung

$x(t)$

$\hat{x}(t)$

$u(t)$

1

2

4

6

Differenzsignal
$x(t-\tau) - \hat{x}(t)$

+

–

– **Figur 2** –

7

Figur 3

u(t)

1

Übertragungssystem

x(t)

Signalnachbildung
verursacht
Laufzeitdifferenz τ

2

$\hat{x}(t)$

τ'   τ'   · -   τ'

⊗ α₁   ⊗ α₂   ⊗ α₃   ⊗ αₙ

Σ

4a

5

+

−

Differenzsignal
$x(t-\tau) - \hat{x}(t)$

6

Signalauswertung

– Figur 3 –

Figur 4

Figur 5

**Europäisches Patentamt**

## EUROPÄISCHER RECHERCHENBERICHT

Nummer der Anmeldung

EP 01 10 1968

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | EP 0 454 406 A (HUGHES AIRCRAFT CO) 30. Oktober 1991 (1991-10-30) --- | | H03M3/02 |
| A | JP 08 330968 A (TEXAS INSTR INC &LT;TI&GT;) 13. Dezember 1996 (1996-12-13) --- | | |
| A | MARTIN U ET AL: "ON DIGITAL SYSTEMS WITH NEGATIVE GROUP DELAY UBER DIGITALE SYSTEME MIT NEGATIVER GRUPPENLAUFZEIT" FREQUENZ, SCHIELE UND SCHON GMBH. BERLIN, DE, Bd. 47, Nr. 5/6, 1. Mai 1993 (1993-05-01), Seiten 106-113, XP000368752 ISSN: 0016-1136 --- | | |

| | |
|---|---|
| | **RECHERCHIERTE SACHGEBIETE (Int.Cl.7)** |
| | H03M |

Der vorliegende Recherchenbericht wurde für alle Patentansprüche erstellt

| Recherchenort | Abschlußdatum der Recherche | Prüfer |
|---|---|---|
| DEN HAAG | 6. September 2001 | Beindorff, W |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...........................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 01 10 1968

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-09-2001

| Im Recherchenbericht angeführtes Patentdokument | Datum der Veröffentlichung | Mitglied(er) der Patentfamilie | Datum der Veröffentlichung |
|---|---|---|---|
| EP 0454406 A | 30-10-1991 | US 5153593 A<br>DE 69117794 D<br>DE 69117794 T<br>JP 2064566 C<br>JP 5152967 A<br>JP 7093581 B | 06-10-1992<br>18-04-1996<br>07-11-1996<br>24-06-1996<br>18-06-1993<br>09-10-1995 |
| JP 08330968 A | 13-12-1996 | KEINE | |

EPO FORM P0461

Für nähere Einzelheiten zu diesem Anhang : siehe Amtsblatt des Europäischen Patentamts, Nr.12/82